(19) Europäisches Patentamt
European Patent Office
Office européen des brevets

(11) **EP 2 161 751 B1**

(12) **FASCICULE DE BREVET EUROPEEN**

(45) Date de publication et mention de la délivrance du brevet:
**14.11.2012 Bulletin 2012/46**

(51) Int Cl.:
***H01L 27/146*** *(2006.01)*

(21) Numéro de dépôt: **09169010.7**

(22) Date de dépôt: **31.08.2009**

(54) **Capteur d'images CMOS à reflexion lumineuse et son procédé de réalisation**

CMOS Bildaufnehmer mit Lichtreflektoren und Herstellungsverfahren dafür

CMOS imager with light reflectors and its method of fabrication

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **05.09.2008 FR 0855974**

(43) Date de publication de la demande:
**10.03.2010 Bulletin 2010/10**

(73) Titulaire: **Commissariat à l'Énergie Atomique et aux Énergies Alternatives**
**75015 Paris (FR)**

(72) Inventeurs:
• **Gidon, Pierre**
**38130 Echirolles (FR)**
• **Cazaux, Yvon**
**38100 Grenoble (FR)**

(74) Mandataire: **Ilgart, Jean-Christophe**
**BREVALEX**
**95 rue d'Amsterdam**
**75378 Paris Cedex 8 (FR)**

(56) Documents cités:
| | |
|---|---|
| EP-A- 1 916 714 | JP-A- 1 082 666 |
| JP-A- 2 264 473 | JP-A- 2 296 368 |
| JP-A- 2006 261 372 | JP-A- 2008 103 668 |
| US-A1- 2006 086 956 | US-A1- 2007 001 100 |
| US-A1- 2007 052 050 | |

EP 2 161 751 B1

## Description

### DOMAINE TECHNIQUE

L'invention concerne le domaine des capteurs d'images, ou imageurs, réalisés en technologie CMOS et de type « back-side », c'est-à-dire tels que la lumière entre dans ces capteurs par le côté opposé à celui où sont disposées les couches d'interconnexions.

L'invention s'applique particulièrement à la réalisation de capteurs d'images à bas coûts utilisés par exemple dans les téléphones portables ou les webcaméras, et plus généralement dans tout type d'appareil photo ou vidéo faisant appel à des capteurs d'images CMOS.

### ÉTAT DE LA TECHNIQUE ANTÉRIEURE

Pour enregistrer électroniquement une image, il existe deux types de capteurs d'images :

- les capteurs CCD, c'est-à-dire des dispositifs à transfert de charges déplaçant un signal électrique reçu depuis des photodiodes vers un amplificateur et un convertisseur numérique,
- les capteurs CMOS, comportant des amplificateurs déversant au moment désiré le signal électrique délivré par chaque photodiode sur des lignes électriques allant à un convertisseur numérique.

Un tel capteur, réalisé en technologie CCD ou CMOS, peut être soit de type « back-side », la lumière capturée entrant alors par la face opposée à celle où se trouvent les couches d'interconnexions électriques du capteur, soit de type « front-side », la lumière capturée passant alors par des zones laissées libre entre les interconnexions électriques pour atteindre le semi-conducteur des photodiodes.

US2007/052050 A1 décrit un capteur d'images de type « back-side » avec une couche d'interconnexion, qui reflète la lumière reçue par la face opposée à celle où se trouve la couche d'interconnexion vers la photodiode.

Les imageurs CMOS « back-side » sont réalisés principalement en technologie silicium, c'est-à-dire comportant des photodiodes et des transistors CMOS réalisés dans une couche de silicium. Afin de minimiser leurs coûts de fabrication, on cherche à réduire le plus possible la taille de ces imageurs afin d'en réaliser le plus grand nombre possible sur un wafer (plaquette) de semi-conducteur. Par ailleurs, on cherche également à augmenter la résolution des images capturées en augmentant le nombre de photodiodes dans chaque imageur, c'est-à-dire le nombre de pixels de chaque imageur. Afin de répondre à ces deux contraintes, on cherche donc à réduire le plus possible les largeurs, ou les pas, des pixels de ces imageurs.

Toutefois, d'autres contraintes doivent également être prises en compte pour la réalisation de ces capteurs. Ces contraintes correspondent aux constantes physiques du semi-conducteur utilisé pour réaliser les photodiodes et les transistors CMOS, telles que l'absorption optique ou les lois de mouvement des charges générées dans ces matériaux. Ces contraintes sur les constantes physiques du matériau semi-conducteur sont contradictoires entre elles car, pour maximiser l'absorption des photons par les photodiodes, il faut maximiser l'épaisseur de la couche de semi-conducteur utilisée, et pour maximiser la collecte des charges générées par l'absorption des photons par les photodiodes, il faut minimiser l'épaisseur de cette couche de semi-conducteur. Un compromis est donc réalisé sur l'épaisseur de la couche de semi-conducteur, et consiste à conserver une épaisseur de semi-conducteur supérieure à environ 2 $\mu$m pour obtenir un fonctionnement correct du capteur, par exemple égale à environ 2,5 $\mu$m.

Bien qu'il soit techniquement possible de réduire la largeur, ou le pas, des pixels à une dimension inférieure à environ 2 $\mu$m, les effets dus à l'épaisseur de semi-conducteur utilisé, tels que l'absorption des photons en incidence oblique ou la diffusion latérale des électrons générés, ne permettent pas de réaliser cette réduction de la largeur des pixels sans une modification de la structure même du pixel, compte tenu de l'épaisseur minimale de 2 $\mu$m de la couche de semi-conducteur.

### EXPOSÉ DE L'INVENTION

Un but de la présente invention est de proposer un capteur d'image, ainsi qu'un procédé de réalisation d'un tel capteur, dont la structure soit compatible avec une couche de semi-conducteur d'épaisseur réduite tout en conservant les éléments de la structure classique des pixels, et présentant un bon rendement de conversion des photons par les photodiodes.

Pour cela, la présente invention propose un capteur d'images selon la revendication 1.

Par rapport à un capteur d'images de l'art antérieur, ce capteur comporte une zone « front-side », c'est-à-dire une zone où sont disposées les couches d'interconnexions, modifiée par la présence de moyens de réflexion lumineuse. Ces moyens de réflexion lumineuse n'impliquent aucune modification de la zone « back-side » du capteur. Ainsi, cette modification de la structure n'est pas bloquante pour d'éventuelles modifications ultérieures de la structure.

Grâce aux moyens de réflexion lumineuse disposés dans la couche diélectrique, on augmente l'absorption des photons dans la couche de semi-conducteur, ainsi que le rendement de conversion des photons dans cette couche, ce qui autorise une réduction de l'épaisseur de la couche de semi-conducteur sans remettre en cause la structure générale du capteur, en ne modifiant que la zone des interconnexions électriques, sans modifier la structure générale existante des couches d'interconnexions électriques. La réduction de l'épaisseur de la couche de semi-conducteur associée à la présence de moyens de réflexion lumineuse permet donc de minimiser la diaphotie électronique, c'est-à-dire le mélange des signaux entre des pixels adjacents dans le capteur d'images et augmente la collecte des charges générées par l'absorption des photons.

Compte tenu de la réduction de l'épaisseur de la couche de semi-conducteur, il est donc possible de réduire la largeur, ou le pas, des pixels de ce capteur, permettant l'obtention d'un capteur comportant plus de pixels pour une même surface occupée, sans que les phénomènes d'absorption des photons en incidence oblique ou de diffusion latérale des électrons générés ne viennent perturber le fonctionnement du capteur.

De plus, la présence de ces moyens de réflexion lumineuse n'empêche pas la présence de diélectrique en contact avec la surface de la couche de semi-conducteur, ce qui limite l'impact électronique sur le capteur d'images.

Indépendamment de la réduction des largeurs des pixels du capteur, la réduction de l'épaisseur de la couche de semi-conducteur permet de mieux séparer les signaux des pixels et d'améliorer les FTM (fonctions de transfert de modulation) du capteur, notamment lorsque l'on souhaite conserver une largeur de pixels au moins égale à 2 $\mu$m. De plus, cette réduction de l'épaisseur de la couche de semi-conducteur permet également d'améliorer la séparation des couleurs (effet de franges colorées) réalisée par les filtres colorés du capteur.

La surface des photodiodes, qui se trouve en regard des moyens de réflexion lumineuse, dans un plan passant par la première face de la couche de semi-conducteur, peut être égale ou supérieure à 70 % de la surface totale des photodiodes dans ledit plan passant par la première face de la couche de semi-conducteur.

Les moyens de réflexion lumineuse peuvent comporter au moins une des couches d'interconnexions électriques présentant une surface de réflexion, c'est-à-dire une surface se trouvant en regard de la couche de semi-conducteur, comprise entre 40 % et 80 %, ou entre 50 % et 90 %, ou encore entre 30 % et 90 %, de la surface de la première face de la couche à base de semi-conducteur ou de la surface, en regard de la couche de semi-conducteur, d'une autre des couches d'interconnexions électriques.

Ainsi, on augmente la surface d'au moins une des couches d'interconnexions, ce qui permet de former une surface de réflexion des photons qui traversent la couche de semi-conducteur sans être transformés en signaux électriques par les photodiodes, vers la couche de semi-conducteur. Une ou plusieurs des couches d'interconnexions métalliques peuvent présenter une telle surface de réflexion.

La distance entre ladite couche d'interconnexions électriques réflectrice et la première face de la couche de semi-conducteur peut être supérieure ou égale à 200 nm, ou supérieure ou égale à 300 nm. Ainsi, cette distance permet d'éviter que des champs électriques, créés par le déplacement de charges électriques et régnant dans les couches d'interconnexions électriques, ne viennent perturber le fonctionnement des photodiodes et des transistors du capteur d'images.

Les moyens de réflexion lumineuse peuvent comporter au moins une couche métallique dont les faces principales sont sensiblement parallèles à la première face de la couche de semi-conducteur, les couches d'interconnexions électriques étant disposées entre ladite couche métallique et la couche de semi-conducteur.

La surface d'une des faces principales de la couche métallique peut être sensiblement égale à la surface de la première face de la couche de semi-conducteur. Avec cette variante, on obtient une réflexion lumineuse homogène sur l'ensemble du capteur.

L'épaisseur de la couche métallique peut être comprise entre 10 nm et 100 nm.

Les moyens de réflexion lumineuse comportent au moins une couche à base d'au moins un matériau apte à réaliser une réflexion lumineuse, dont les faces principales sont sensiblement parallèles à la première face de la couche de semi-conducteur, disposée entre les couches d'interconnexions et la couche de semi-conducteur et traversée par des contacts électriques reliant les couches d'interconnexions électriques aux photodiodes et/ou aux transistors CMOS.

Cette couche réflectrice peut par exemple être réalisée entre des grilles des transistors CMOS disposées dans la couche diélectrique, contre la première face de la couche de semi-conducteur.

La couche de matériau apte à réaliser une réflexion lumineuse peut être à base d'aluminium et/ou de cuivre et/ou de chrome et/ou de silicium amorphe et/ou de silicium polycristallin, et/ou avoir une épaisseur comprise entre 10 nm et 100 nm.

La distance entre la couche de matériau apte à réaliser une réflexion lumineuse et la première face de la couche de semi-conducteur est comprise entre 70 nm et 120 nm, cette valeur pouvant notamment dépendre de la valeur de la longueur d'onde centrale de fonctionnement du dispositif.

Les moyens de réflexion lumineuse peuvent comporter en outre une seconde couche à base d'au moins un matériau diélectrique, ou un espace vide, disposé entre la couche de matériau apte à réaliser une réflexion lumineuse et la première face de la couche de semi-conducteur. Cette seconde couche diélectrique, ou cet espace vide, permet d'améliorer l'absorption des photons réfléchis dans le semi-conducteur en contribuant à la réflexion de ces photons. Lorsque le matériau apte à réaliser une réflexion lumineuse n'est pas de nature métallique, le matériau diélectrique peut être choisi tel que son indice optique soit inférieur à l'indice optique du matériau apte à réaliser une réflexion lumineuse.

Une portion de la couche diélectrique peut être disposée entre la seconde couche diélectrique, ou l'espace vide, et la première face de la couche de semi-conducteur, et avoir une épaisseur comprise entre 1 nm et 10 nm.

L'épaisseur de la couche de matériau apte à réaliser une réflexion lumineuse, et/ou l'épaisseur de la ou des couches diélectriques et/ou l'épaisseur du vide se trouvant entre la première face de la couche de semi-conducteur et la couche de matériau apte à réaliser une réflexion lumineuse, peut être égale à environ :

$$\frac{\lambda c \times n}{4},$$

avec

- $\lambda c$ : longueur d'onde centrale de la gamme de longueurs d'ondes de fonctionnement du capteur d'images, et qui traverse la couche de semi-conducteur,
- $n$ : indice optique du matériau de ladite couche, ou partie réelle de l'indice optique du matériau de ladite couche.

La couche de matériau apte à réaliser une réflexion lumineuse peut être reliée électriquement à des zones dopées formées dans la couche de semi-conducteur. Dans ce cas, la couche de réflexion lumineuse peut former également une électrode de polarisation reliée électriquement aux photodiodes et/ou aux transistors CMOS.

La couche de semi-conducteur a une épaisseur comprise entre 1 $\mu$m et 1,5 $\mu$m.

L'invention concerne également un procédé de réalisation d'un capteur d'images selon la revendication 13.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

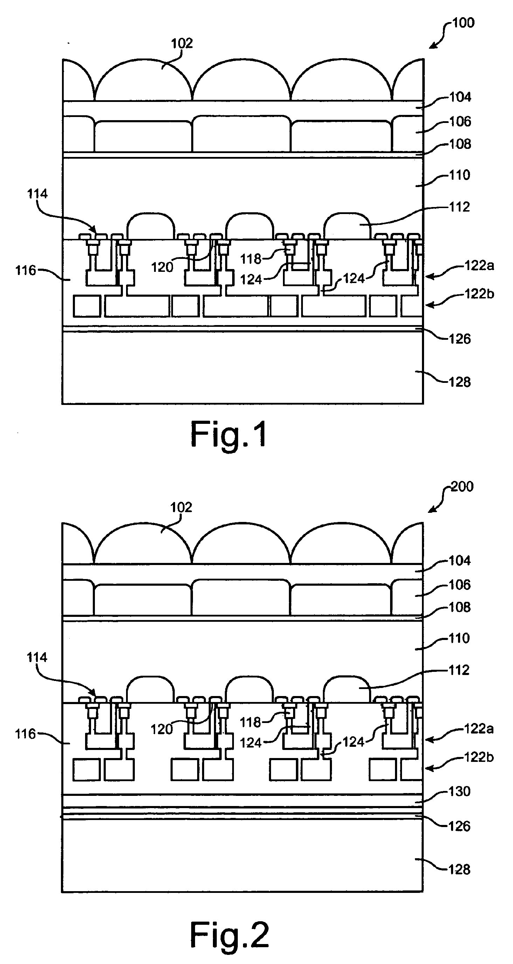

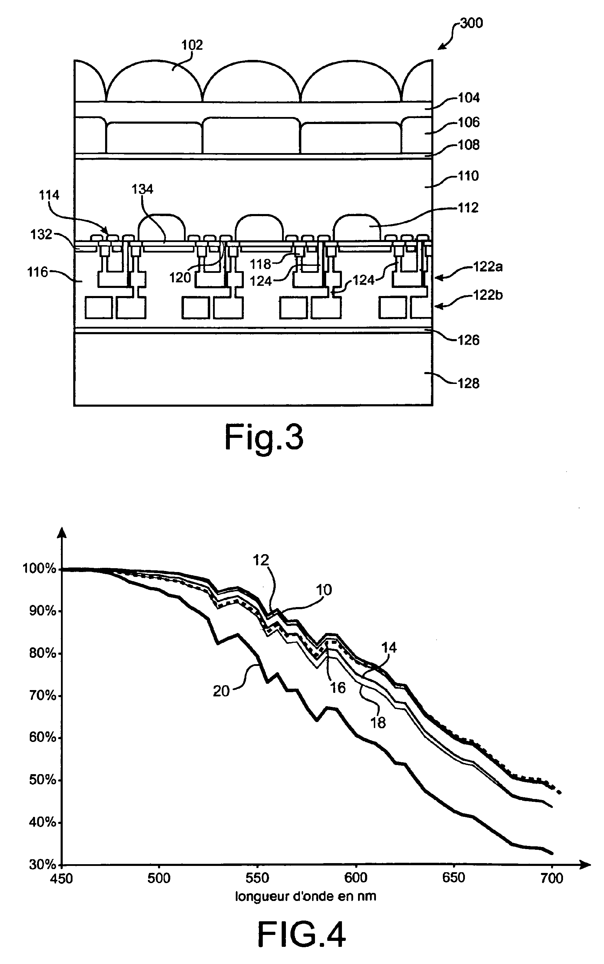

- les figures 1 et 2 représentent des capteurs d'images, exemples permettant la compréhension du problème technique, respectivement selon un premier et un second modes de réalisation, et la figure 3 représente un capteur d'images, objet de la présente invention, selon un troisième modes de réalisation,
- la figure 4 représente des simulations d'absorption de photons dans la couche de semi-conducteur d'un capteur d'images, objet de la présente invention, selon le troisième mode de réalisation, en fonction de la longueur d'onde de la lumière reçue et selon la nature des matériaux de la couche réflectrice et de la couche diélectrique utilisées pour une réflexion lumineuse,

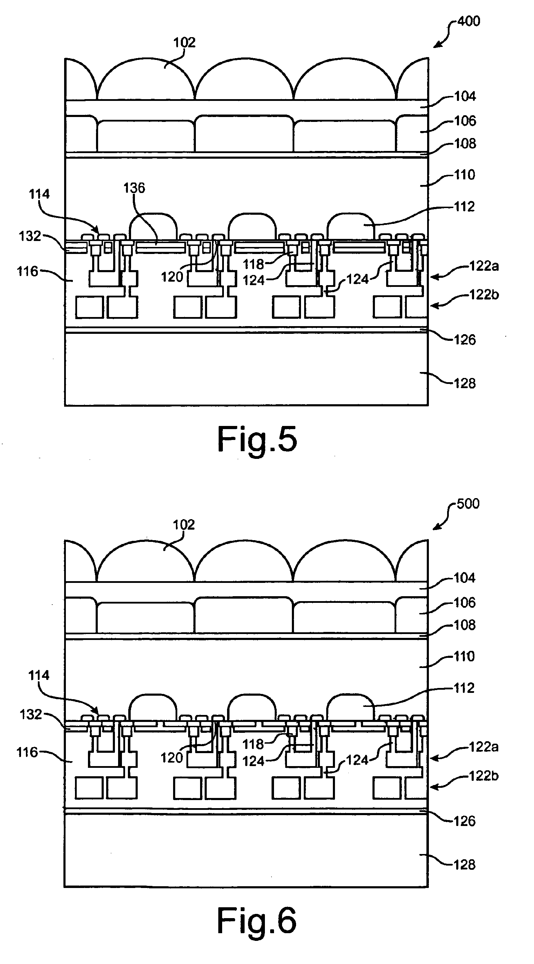

- les figures 5 et 6 représentent des capteurs d'images, objets de la présente invention, respectivement selon un quatrième et cinquième modes de réalisation,

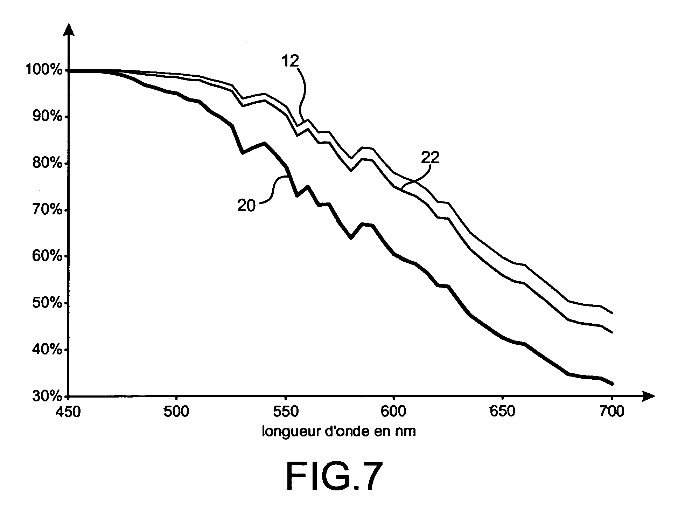

- la figure 7 représente des simulations d'absorption de photons dans la couche de semi-conducteur d'un capteur d'images, objet de la présente invention, selon le quatrième mode de réalisation, en fonction de la longueur d'onde de la lumière reçue et selon la nature des matériaux de la couche réflectrice et de la couche diélectrique utilisées pour une réflexion lumineuse.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

On se réfère tout d'abord à la figure 1 qui représente un capteur d'image 100 selon un premier mode de réalisation, étant un exemple permettant la compréhension du problème technique.

Le capteur d'images 100 comporte une première zone « back-side » par laquelle entre la lumière des images capturées. Cette zone comporte des micro-lentilles 102 disposées sur une couche de planarisation 104 formée sur des filtres colorés 106. Chaque micro-lentille 102 peut avoir une largeur inférieure à environ 2 $\mu$m, par exemple comprise entre environ 1 $\mu$m et 1,7 $\mu$m. La largeur d'une micro-lentille 102 correspond à la largeur, ou le pas, d'un pixel du capteur d'images 100. Ces filtres colorés 106 peuvent par exemple être disposés selon une structure dite de « Bayer », une telle structure comportant un filtre rouge, deux filtres vert et un filtre bleu disposés les uns à côté des autres sous la forme d'une matrice carrée. La zone « back-side » comporte également une couche de passivation 108, par exemple à base de SiO$_x$N$_y$, tel que du SiO$_2$ et/ou de Si$_3$N$_4$, formée entre les filtres colorés 106 et une couche de semi-conducteur 110. Cette zone « back-side » a une épaisseur égale à la somme des épaisseurs des micro-lentilles 102, de la couche de planarisation 104, des filtres colorés 106 et de la couche de passivation 108, soit une épaisseur totale supérieure à environ 1 $\mu$m ou comprise entre environ 1 $\mu$m et 3 $\mu$m.

La couche de semi-conducteur 110, de préférence à base de silicium mais pouvant également être à base de tout autre semi-conducteur, forme une zone d'absorption de la lumière entrée depuis la zone « back-side » et de séparation des charges générées par les champs électriques dans le semi-conducteur 110. Cette couche 110 a une épaisseur comprise entre environ 1 µm et 2 µm, par exemple égale à environ 1,5 µm.

Des photodiodes 112, ainsi que des transistors CMOS 114 sont réalisés dans la couche de silicium 110. Les photodiodes 112 collectent les charges crées par les photons reçus depuis la zone « back-side » du capteur 100 pour les transformer en signaux électriques. Ces signaux électriques sont ensuite utilisés à travers les transistors CMOS 114 afin d'être amplifiés et amenés hors de la matrice de photodiodes et de transistors.

Le capteur d'images 100 comporte également une zone « front-side » comprenant une couche diélectrique 116, par exemple à base de $SiO_xN_y$, tel que du $SiO_2$ et/ou de $Si_3N_4$, dans laquelle sont réalisés les grilles 118 des transistors CMOS 114, des contacts électriques 120 reliés aux sources et drains des transistors CMOS 114, ainsi que des couches d'interconnexions électriques 122. Sur la figure 1, seules deux couches d'interconnexions 122a et 122b sont représentées. Toutefois, le capteur 100 peut comporter un nombre plus important de couches d'interconnexions, par exemple jusqu'à 15 couches d'interconnexions, appelées également niveaux d'interconnexions. Des via 124, ou trous métallisés, sont également réalisés dans la couche diélectrique 116 et relient électriquement les contacts 120 et les grilles 118 aux couches d'interconnexions 122, ainsi que les différentes couches d'interconnexions 122 entre elles. Ces via 124 forment des contacts électriques verticaux reliant ces différents éléments.

Enfin, le capteur d'images 100 comporte une couche de collage 126 reliant la couche diélectrique 116 à une plaque de support, ou substrat, 128.

Dans ce premier mode de réalisation, le capteur 100 comporte une seconde couche d'interconnexion 122b présentant, en regard de la couche de semi-conducteur 110, une surface plus importante qu'une couche d'interconnexion d'un capteur d'images CMOS classique. Or, étant donné que les couches d'interconnexion 122 sont à base de métal, par exemple de l'aluminium et/ou du tungstène et/ou du cuivre, cette surface permet de réaliser une réflexion optique des photons qui ont traversé la couche de semi-conducteur 110 mais qui n'ont pas été transformés en signaux électriques par les photodiodes 112, et de les renvoyer ainsi vers la couche de semi-conducteur 110. Ainsi, on améliore le taux d'absorption des photons par les photodiodes 112, ce qui permet de réduire l'épaisseur de la couche de silicium 110, et donc de réduire la largeur des pixels et de réduire ou supprimer la diaphotie électronique du capteur 100 tout en améliorant le rendement de conversion du capteur 100. De plus, des portions de cette seconde couche d'interconnexions 122b se trouvent en regard des photodiodes 112, afin de renvoyer les photons vers les photodiodes.

Dans une variante de ce premier mode de réalisation, il est possible que ce ne soit pas le second niveau d'interconnexions 122b qui présente une surface apte à réaliser une réflexion optique des photons, mais le premier niveau d'interconnexions 122a, ou encore les deux, et/ou un ou plusieurs autres niveaux d'interconnexions si le capteur 100 comporte plus de deux niveaux d'interconnexions électriques.

Si l'on souhaite maximiser la réflexion optique dans le capteur, on choisit de préférence la couche d'interconnexions la plus proche de la couche de semi-conducteur 110, c'est-à-dire le premier niveau d'interconnexions 122a, pour former la couche réflectrice. Par contre, si l'on souhaite réaliser une réflexion lumineuse sans complexifier la réalisation des passages des vias 124 vers la couche de semi-conducteur 110, on choisit de préférence la seconde couche d'interconnexions 122b (ou au moins l'une des couches d'interconnexions inférieures si le capteur comporte plus de deux niveaux d'interconnexions) pour former la couche réflectrice.

De plus, la distance entre la couche d'interconnexions servant de couche réflectrice et la couche de silicium 110 est supérieure à environ 300 nm, ou supérieure à environ 200 nm, afin d'éviter des perturbations dans le fonctionnement des photodiodes 112 et des transistors 114 dues à la présence de champs magnétiques au niveau des couches d'interconnexions 122.

Bien que les dimensions de la couche d'interconnexions 122b soient choisies afin de maximiser la réflexion lumineuse, notamment pour maximiser la surface de réflexion vers les photodiodes, les dimensions de cette couche sont également choisies afin de ne pas court-circuiter les couches d'interconnexions 122a, 122b entre elles, ni les différentes parties de la couche d'interconnexion 122b elle-même. De manière générale, le rapport entre la surface de réflexion de la couche d'interconnexions 122b, c'est-à-dire la surface de la face de cette couches 122b se trouvant en regard de la couche de semi-conducteur 110, et la surface d'une des faces principales de la couche de semi-conducteur 110 ou de la couche d'interconnexions 122a peut par exemple être compris entre environ 50 % et 90 %. Ainsi, il est possible de réaliser une réflexion comprise entre environ 40 % et 75 %, ou entre 40 % et 80 %, de la lumière ayant traversée la couche de semi-conducteur 110 et dont les photons n'ont pas été transformé en signaux électriques, étant un exemple permettant la compréhension du problème technique.

On se réfère maintenant à la figure 2 qui représente un capteur d'images 200 selon un second mode de réalisation.

Par rapport au capteur d'images 100 représenté sur la figure 1, le capteur d'images 200 comporte deux niveaux d'interconnexions 122a, 122b présentant une surface, vis-à-vis de la couche de semi-conducteur 110, similaire à celle présentée par la seconde couche d'interconnexions 122b du capteur d'images 100, c'est-à-dire ne présentant pas une surface spécialement adaptée pour réaliser une réflexion maximale des photons non transformés en signaux électriques vers la couche de silicium 110. Ainsi, contrairement au capteur d'images 100, ce n'est pas la seconde couche d'interconnexions 122b qui sert de couche réflectrice, mais une couche additionnelle 130 formée sous la seconde couche d'interconnexions 122b. Cette couche 130 est à base de métal, par exemple similaire au métal des couches d'interconnexions 122, et est réalisée au niveau de toute la surface de la couche diélectrique 116, présentant ainsi une surface de réflexion correspondant à la totalité de la surface d'une des faces principales de la couche de silicium 110 se trouvant en regard de cette couche additionnelle réflectrice 130. L'épaisseur de métal choisie pour réaliser la réflexion des photons peut être faible : la couche métallique 130 peut avoir une épaisseur comprise entre environ 10 nm et 100 nm. Cette couche 130 permet de réfléchir tous les photons qui sont passés par les ouvertures des couches 122a, 122b, entre les interconnexions de ces couches 122a, 122b.

Cette couche additionnelle 130 présente au niveau de toute la surface de la couche de semi-conducteur 110 permet d'obtenir une réflexion optique homogène au niveau de toute la couche de semi-conducteur 110, et cela sans modifier la géométrie des couches d'interconnexions 122a, 122b du capteur 200.

On se réfère maintenant à la figure 3 qui représente un capteur d'images 300 selon un troisième mode de réalisation, étant un objet de la présente invention.

Contrairement au capteur d'images 100 représenté sur la figure 1, le capteur d'images 300 comporte deux niveaux d'interconnexions 122a, 122b ne présentant pas une surface optimisée pour réaliser la réflexion des photons vers la couche de silicium 110, de manière analogue au capteur 200. Ainsi, contrairement au capteur d'images 100, ce n'est pas la seconde couche d'interconnexions 122b qui sert de couche réflectrice, mais une couche additionnelle 132 formée au-dessus des couches d'interconnexions 122, dans la couche diélectrique 116.

Cette couche additionnelle 132 est par exemple à base de métal tel que de l'aluminium et/ou du cuivre et/ou chrome, et/ou de semi-conducteur tel que du silicium amorphe et/ou du silicium polycristallin, et/ou tout autre matériau adapté à réaliser une telle réflexion lumineuse. Son épaisseur est par exemple comprise entre environ 10 nm et 100 nm. Dans ce troisième mode de réalisation, l'épaisseur de la couche additionnelle 132 est égale à environ 30 nm. De plus, lorsque la couche additionnelle 132 est à base de semi-conducteur et/ou de tout autre matériau de nature non métallique, le matériau de la couche réflectrice 132 peut avoir un indice optique supérieur à environ 3, formant une couche à fort indice optique.

La couche réflectrice 132 n'est pas appliquée directement contre la face supérieure de la couche diélectrique 116. Une partie de la couche diélectrique 116 se trouvant entre la couche réflectrice 132 et la face supérieure de la couche diélectrique 116 forme une portion diélectrique 134 d'épaisseur comprise entre environ 70 nm et 120 nm, et d'indice optique compris entre environ 1,35 et 1,6, formant une couche à faible indice optique.

Cette couche additionnelle 132 ne sert pas à la conduction de signaux électriques, mais permet de réfléchir des photons ayant traversé la couche de silicium 110 et qui n'ont pas été absorbé et transformé en signaux électriques par les photodiodes 112. Ainsi, la couche réflectrice 132 n'est pas électriquement en contact avec les grilles 118 et les contacts drain-source 120, mais traversée par ces grilles 118 et ces contacts 120, et comporte des zones d'isolation électrique au niveau des passages des grilles 118 et des contacts 120 dans la couche 132. De plus, la couche additionnelle 132 est formée telle qu'une grande partie (au moins 70 % de la surface totale) ou la totalité de la surface des photodiodes 112 se trouve en regard de la couche additionnelle 132.

La figure 4 représente des simulations de l'absorption de photons dans la couche de semi-conducteur 110 du capteur d'images 300 en fonction de la longueur d'onde de la lumière capturée. Les différentes courbes sont tracées pour différents matériaux de la couche réflectrice 132 et de la couche diélectrique 116. Ces simulations correspondent à une absorption de photons dans une couche de silicium 110 d'épaisseur égale à environ 1,5 $\mu$m, dont l'épaisseur de la couche réflectrice 132 est égale à environ 30 nm et dont l'épaisseur de la couche diélectrique 134 est égale à environ 90 nm.

La courbe 10 représente cette absorption pour une couche réflectrice 132 à base d'aluminium et une couche diélectrique 116 à base de $SiO_2$. On voit que l'absorption est sensiblement similaire à celle obtenue dans un capteur d'image de l'art antérieur de type CMOS « back-side » comportant une couche de silicium d'épaisseur égale à environ 2,5 $\mu$m et mais pas de couche réflectrice (représentée par la courbe 12).

La courbe 14, 16 et 18 représentent les performances obtenues dans les cas d'une couche d'absorption 132 respectivement à base de silicium amorphe ou polycristallin, de cuivre et de chrome, et une couche diélectrique 116 à base de $SiO_2$. On observe que dans ces cas, l'absorption est légèrement inférieure à celle réalisée avec une couche réflectrice 132 à base d'aluminium et une couche diélectrique 116 à base de $SiO_2$.

La courbe 20 représente l'absorption de photons dans une couche de silicium d'épaisseur égale à environ 1,5 $\mu$m dans un capteur d'images de l'art antérieur de type CMOS « back-side », c'est-à-dire ne comportant pas de moyens de réflexion lumineuse. En comparant ces différentes courbes, on observe que l'absorption dans la couche mince sans diaphotie d'épaisseur égale à environ 1,5 $\mu$m est supérieure à celle réalisée dans un même dispositif mais qui ne comporte pas de couche réflectrice.

On se réfère maintenant à la figure 5 qui représente un capteur d'images 400 selon un quatrième mode de réalisation étant un objet de la présente invention.

En plus de la couche réflectrice 132 présente dans le capteur 300 de la figure 3, le capteur 400 comporte en outre une couche diélectrique 136 d'indice optique inférieure à celui du matériau de la couche réflectrice 132. Cette configuration est particulièrement intéressante lorsque ce matériau diélectrique est différent du matériau diélectrique de la couche 116. Une portion de la couche diélectrique 116 d'épaisseur comprise entre environ 1 nm et 10 nm est également disposée au-dessus de la couche diélectrique 136. Cette couche diélectrique 136 permet d'améliorer l'absorption et la réflexion des photons dans la couche semi-conductrice 110.

Dans une variante de ce quatrième mode de réalisation, la couche diélectrique 136 peut être remplacée par un espace vide. Cet espace vide rempli la même fonction que la couche diélectrique 136.

Dans une autre variante, il serait possible que la couche réflectrice soit à base d'un diélectrique. Par exemple, la couche réflectrice peut être à base de $TiO_2$, la couche diélectrique 136 étant dans ce cas à base d'un matériau poreux, par exemple un oxyde de type $Si_xO_yN_z$. La courbe 22 de la figure 7 représente l'absorption de photons dans une couche de silicium d'épaisseur égale à environ 1,5 $\mu$m dans un capteur d'images comportant une couche réflectrice à base de $TiO_2$ et une couche diélectrique 136 à base d'un matériau poreux. En comparant cette courbe aux courbes 12 et 20 qui représentent respectivement l'absorption de photons dans une couche de silicium d'épaisseur égale à environ 2,5 $\mu$m et 1,5 $\mu$m dans un capteur d'images de l'art antérieur de type CMOS « back-side », on observe que les valeurs de cette courbe 22 sont proches des valeurs de la courbe 12.

Dans une autre variante, étant un exemple permettant la compréhension du problème technique, il serait possible de remplacer la couche réflectrice 132 et la couche diélectrique 136 par un empilement de couches formé par une alternance de couches de fort et faible indices optiques.

L'épaisseur de la couche réflectrice 132 et/ou de la couche diélectrique 136 et/ou de la partie de la couche diélectrique 116 se trouvant entre la couche diélectrique 136 et la couche de semi-conducteur 110, est de préférence choisie égale à environ $\dfrac{\lambda c \times n}{4}$, avec

$\lambda c$ : longueur d'onde centrale de la gamme de fonctionnement du capteur et qui traverse la couche de semi-conducteur 110, et n partie réelle de l'indice optique du matériau de la couche réflectrice 132. Pour un capteur fonctionnant dans la gamme des longueurs d'ondes visibles, cette longueur centrale peut être égale à environ 570 nm. Cette épaisseur optimum est appelée épaisseur de résonance à la longueur d'onde centrale.

On se réfère à la figure 6 qui représente un capteur d'images 500 selon un cinquième mode de réalisation, étant un objet de la présente invention.

Par rapport au capteur d'images 300, la couche réflectrice 132, en plus de réaliser une réflexion optique des photons dans la couche de semi-conducteur 110, forme également une électrode de polarisation des photodiodes 112, sans toutefois délivrer de courant ni transférer de signal depuis les photodiodes 112. Ce rôle de polarisation est réalisé en contactant les zones dopées de la couche de semi-conducteur 110 formant les photodiodes 112. L'épaisseur de la couche réflectrice 132, qui est à base d'un métal de nature différente des métaux formant les autres couches d'interconnexions 122, est par exemple égale à environ 30 nm.

Ces capteurs d'images peuvent être réalisés en technologie CMOS classique. Pour cela, à partir de la couche de semi-conducteur 110, on réalise tout d'abord les diffusions de dopants dans cette couche 110 pour former les zones actives des photodiodes 112 et des transistors CMOS 114. Les couches d'interconnexions, ainsi que les moyens de réflexion lumineuse (formée par une ou plusieurs des couches d'interconnexions et/ou des couches additionnelles telles que précédemment décrites) sont alors réalisés par des étapes de photolithographie et gravure, les matériaux métalliques pouvant être déposés par des étapes de croissance ou de dépôt. Le matériau diélectrique 116 est déposé au fur et à mesure entre les réalisations des différentes couches, afin de recouvrir les couches d'interconnexions et/ou de réflexion lumineuse.

Cet ensemble est ensuite reporté sur le substrat 128 par l'intermédiaire de la couche de collage 126. La face de la couche de semi-conducteur 110 opposée à celle en contact avec le diélectrique 116 est ensuite amincie. Enfin, les éléments de la zone « back-side », c'est-à-dire la couche de passivation 108, les filtres colorés 106, la couche de planarisation 104 et les micro-lentilles 102 sont réalisées sur la face précédemment amincie de la couche de semi-conducteur 110.

## Revendications

1.  Capteur d'images (100, 200, 300, 400, 500) comportant au moins :

    - des photodiodes (112) et des transistors (114) de type CMOS réalisés dans une couche (110) à base d'au moins un semi-conducteur d'épaisseur comprise entre 1 $\mu$m et 1,5 $\mu$m,
    - une couche (116) à base d'au moins un diélectrique dans laquelle sont réalisées des couches d'interconnexions électriques (122a, 122b) reliées électriquement entre elles et/ou aux photodiodes (112) et/ou aux transistors CMOS (114), ladite couche diélectrique (116) étant disposée contre une première face de la couche de semi-conducteur (110) opposée à une seconde face de la couche de semi-conducteur (110) par laquelle la lumière reçue par le capteur (100-500) depuis l'extérieur est destinée à entrer,
    - des moyens de réflexion lumineuse (122b, 130, 132, 136) disposés dans la couche diélectrique (116), en regard des photodiodes (112), et aptes à refléter au moins une partie de la lumière reçue par le capteur (100-500) vers les photodiodes (112), comportant au moins une couche (132) à base d'au moins un matériau apte à réaliser une réflexion lumineuse, dont les faces principales sont parallèles à la première face de la couche de semi-conducteur, **caractérisé en ce que** la au moins une couche (132) à base d'au moins un matésicur lumineuse est disposée entre les couches d'interconnexions (122a, 122b) et la couche de semi-conducteur (110), et traversée par des contacts électriques (124) reliant les couches d'interconnexions électriques (122a, 122b) aux photodiodes (112) et/ou aux transistors CMOS (114),

et **en ce que** dans lequel la distance entre la couche (132) de matériau apte à réaliser une réflexion lumineuse et la première face de la couche de semi-conducteur (110) est comprise entre 70 nm et 120 nm.

2. Capteur d'images (100-500) selon la revendication 1, dans lequel la surface des photodiodes (112) qui se trouve en regard des moyens de réflexion lumineuse (122b, 130, 132, 136), dans un plan passant par la première face de la couche de semi-conducteur (110), est égale ou supérieure à 70 % de la surface totale des photodiodes (112) dans ledit plan passant par la première face de la couche de semi-conducteur (110).

3. Capteur d'images (100) selon l'une des revendications précédentes, dans lequel les moyens de réflexion lumineuse comportent au moins une des couches d'interconnexions électriques (122b) présentant une surface de réflexion comprise entre 50 % et 90 % de la surface de la première face de la couche de semi-conducteur (110) ou de la surface, en regard de la couche de semi-conducteur (110), d'une autre (122a) des couches d'interconnexions électriques.

4. Capteur d'images (100) selon la revendication 3, dans lequel la distance entre ladite couche d'interconnexions électriques réflectrice et la première face de la couche de semi-conducteur est supérieure ou égale à 200 nm.

5. Capteur d'images (200) selon l'une des revendications 1 ou 2, dans lequel les moyens de réflexion lumineuse comportent au moins une couche métallique (130) dont les faces principales sont parallèles à la première face de la couche de semi-conducteur (110), les couches d'interconnexions électriques (122a, 122b) étant disposées entre ladite couche métallique (130) et la couche de semi-conducteur (110).

6. Capteur d'images (200) selon la revendication 5, dans lequel la surface d'une des faces principales de la couche métallique (130) est égale à la surface de la première face de la couche de semi-conducteur (110).

7. Capteur d'images (200) selon l'une des revendications 5 ou 6, dans lequel l'épaisseur de la couche métallique (130) est comprise entre 10 nm et 100 nm.

8. Capteur d'images (300, 400, 500) selon l'une des revendications précédentes, dans lequel la couche (132) de matériau apte à réaliser une réflexion lumineuse est à base d'aluminium et/ou de cuivre et/ou de chrome et/ou de silicium amorphe et/ou de silicium polycristallin, et/ou a une épaisseur comprise entre 10 nm et 100 nm.

9. Capteur d'images (400) selon l'une des revendications précédentes, dans lequel les moyens de réflexion lumineuse comportent en outre une seconde couche (136) à base d'au moins un matériau diélectrique, ou un espace vide, disposé entre la couche (132) de matériau apte à réaliser une réflexion lumineuse et la première face de la couche de semi-conducteur (110).

10. Capteur d'images (400) selon la revendication 9, dans lequel une portion de la couche diélectrique (116) est disposée entre la seconde couche diélectrique (136), ou l'espace vide, et la première face de la couche de semi-conducteur (110), et a une épaisseur comprise entre 1 nm et 10 nm.

11. Capteur d'images (300, 400, 500) selon l'une des revendications précédentes, dans lequel l'épaisseur de la couche (132) de matériau apte à réaliser une réflexion lumineuse, et/ou l'épaisseur de la ou des couches diélectriques (136, 116) et/ou l'épaisseur du vide se trouvant entre la première face de la couche de semi-conducteur (110) et la couche (132) de matériau apte à réaliser une réflexion lumineuse, est égale à :

$$\frac{\lambda c \times n}{4},$$

avec

- $\lambda c$ : longueur d'onde centrale de la gamme de longueurs d'ondes de fonctionnement du capteur d'images (300, 400, 500), et qui traverse la couche de semi-conducteur (110),
- n : partie réelle de l'indice optique du matériau de ladite couche.

**12.** Capteur d'images (500) selon l'une des revendications précédentes, dans lequel la couche (132) de matériau apte à réaliser une réflexion lumineuse est reliée électriquement à des zones dopées formées dans la couche de semi-conducteur (110).

**13.** Procédé de réalisation d'un capteur d'images (100-500), comportant au moins les étapes de :

- réalisation de zones dopées de photodiodes (112) et de transistors CMOS (114) dans une couche (110) à base d'au moins un semi-conducteur d'épaisseur comprise entre 1 $\mu$m et 1,5 $\mu$m,
- réalisation de couches d'interconnexions électriques (122a, 122b) reliées électriquement entre elles et/ou aux photodiodes (112) et/ou aux transistors CMOS (114) dans une couche (116) à base d'au moins un diélectrique disposée contre une première face de la couche à base de semi-conducteur (110) opposée à une seconde face de la couche à base de semi-conducteur (110) par laquelle la lumière reçue par le capteur (100-500) depuis l'extérieur est destinée à entrer,

et comportant en outre la réalisation de moyens de réflexion lumineuse 122b, 130, 132, 136) disposés dans la couche diélectrique (116), en regard des photodiodes (112), et aptes à refléter au moins une partie de la lumière reçue par le capteur (100-500) vers les photodiodes (112), comportant au moins une couche (132) à base d'au moins un matériau apte à réaliser une réflexion lumineuse, dont les faces principales sont parallèles à la première face de la couche de semi-conducteur, **caractérisé en ce que** la au moins une couche (132) à base d'au moins un materiau apte à réaliser une réflexion lumineuse est disposée entre les couches d'interconnexions (122a, 122b) et la couche de semi-conducteur (110), et traversée par des contacts électriques (124) reliant les couches d'interconnexions électriques (122a, 122b) aux photodiodes (112) et/ou aux transistors CMOS (114), et **en ce que** dans lequel la distance entre la couche (132) de matériau apte à réaliser une réflexion lumineuse et la première face de la couche de semi-conducteur (110) est comprise entre 70 nm et 120 nm.

**Claims**

**1.** Image sensor (100, 200, 300, 400, 500) comprising at least:

- photodiodes (112) and CMOS-type transistors (114) produced in a layer (110) comprising at least one semiconductor having a thickness of between 1 $\mu$m and 1.5 $\mu$m,
- a layer (116) comprising at least one dielectric in which electrical interconnect layers (122a, 122b) are made, which are electrically connected to one another and/or to the photodiodes (112) and/or CMOS transistors (114), said dielectric layer (116) being arranged against a first face of the semiconductor layer (110) opposite a second face of the semiconductor layer (110) through which the light received by the sensor (100-500) from the exterior is intended to enter,
- light-reflecting means (122b, 130, 132, 136) arranged in the dielectric layer (116), opposite the photodiodes (112), and capable of reflecting at least a portion of the light received by the sensor (100-500) towards the photodiodes (112), comprising at least one layer (132) comprising at least one light-reflecting material, the principal faces of which are substantially parallel to the first face of the semiconductor layer, **characterized in that** said at least one layer (132) comprising at least one light-reflecting material is arranged between the interconnect layers (122a, 122b) and the semiconductor layer (110) and through which electrical contacts (124) pass, which connect the electrical interconnect layers (122a, 122b) to the photodiodes (112) and/or to the CMOS transistors (114),

and **in that** the distance between the layer (132) of light-reflecting material and the first face of the semiconductor layer (110) is between 70 nm and 120 nm.

**2.** Image sensor (100-500) according to claim 1, wherein the surface of the photodiodes (112), which is situated opposite the light-reflecting means (122b, 130, 132, 136), in a plane passing through the first face of the semiconductor layer (110), is equal to or greater than 70% of the total surface area of the photodiodes (112) in said plane passing through the first face of the semiconductor layer (110).

**3.** Image sensor (100) according to one of the preceding claims, wherein the light-reflecting means comprise at least one of the electric interconnect layers (122b) having a reflective surface of between 50% and 90% of the surface of the first face of the semiconductor layer (110) or of the surface opposite the semiconductor layer (110) of another (122a) one of the electric interconnect layers.

**4.** Image sensor (100) according to claim 3, wherein the distance between said reflective electrical interconnect layer and the first face of the semiconductor layer is greater than or equal to 200 nm.

**5.** Image sensor (200) according to one of claims 1 or 2, wherein the light-reflecting means comprise at least one layer containing at least one metallic layer (130), the principal faces of which are substantially parallel to the first face of the semiconductor layer (110), the electric interconnect layers (122a, 122b) being arranged between said metallic layer (130) and the semiconductor layer (110).

6. Image sensor (200) according to claim 5, wherein the surface of one of the principal faces of the metallic layer (130) is equal to the surface of the first face of the semiconductor layer (110).

7. Image sensor (200) according to one of claims 5 or 6, wherein the thickness of the metallic layer (130) is between 10 nm and 100 nm.

8. Image sensor (300, 400, 500) according to one of the preceding claims, wherein the layer (132) of light-reflecting material comprises aluminium and/or copper and/or chromium and/or amorphous silicon and/or polycrystalline silicon, and/or has a thickness of between 10 nm and 100 nm.

9. Image sensor (400) according to one of the preceding claims, wherein the light-reflecting means further comprise a second layer (136) comprising at least one dielectric material, or a void space, which is arranged between the layer (132) of light-reflecting material and the first face of the semiconductor layer (110).

10. Image sensor (400) according to claim 9, wherein a portion of the dielectric layer (116) is arranged between the second dielectric layer (136), or the void space, and the first face of the semiconductor layer (110), and has a thickness of between 1 nm and 10 nm.

11. Image sensor (300, 400, 500) according to one of the preceding claims, wherein the thickness of the layer (132) of light-reflecting material, and/or the thickness of the dielectric layer (136, 116) or layers and/or the thickness of the void situated between the first face of the semiconductor layer (110) and the layer (132) of light-reflecting material is equal to:

$$\frac{\lambda c \times n}{4},$$

with

- $\lambda c$: the central wavelength of the range of operating wavelengths of the image sensor (300, 400, 500), and which passes through the semiconductor layer (110),

- n: the real part of the optical index of the material of said layer.

12. Image sensor (500) according to one of the preceding claims, wherein the layer (132) of light-reflecting material is electrically connected to doped regions formed in the semiconductor layer (110).

13. Method of producing an image sensor (100-500), comprising at least the following steps of:

- producing doped regions of photodiodes (112) and CMOS transistors (114) in a layer (110) comprising at least one semiconductor having a thickness of between 1 $\mu$m and 1.5 $\mu$m,
- producing electrical interconnect layers (122a, 122b) which are electrically connected to one another and/or to the photodiodes (112) and/or to the CMOS transistors (114) in a layer (116) comprising at least one dielectric arranged against a first face of the semiconductor layer (110), which is opposite a second face of the semiconductor layer (110) through which the light received by the sensor (100-500) from the exterior is intended to enter,

and further comprising the production of light-reflecting means (122b, 130, 132, 136) arranged in the dielectric layer (116), opposite the photodiodes (112), and capable of reflecting at least a portion of the light received by the sensor (100-500), towards the photodiodes (112), comprising at least one layer (132) comprising at least one light-reflecting material, the principal faces of which are substantially parallel to the first face of the semiconductor layer, **characterized in that** said at least one layer (132) comprising at least one light-reflecting material is arranged between the interconnect layers (122a, 122b) and the semiconductor layer (110) and through which electrical contacts (124) pass, which connect the electrical interconnect layers (122a, 122b) to the photodiodes (112) and/or to the CMOS transistors (114),
and **in that** the distance between the layer (132) of light-reflecting material and the first face of the semiconductor layer (110) is between 70 nm and 120 nm.

**Patentansprüche**

1. Bildsensor (100, 200, 300, 400, 500), der wenigstens umfasst:

- Photodioden (112) sowie Transistoren (114) vom CMOS-Typ, die in einer Schicht (110) auf Grundlage eines Halbleiters mit einer Dicke im Bereich zwischen 1 $\mu$m und 1,5 $\mu$m hergestellt sind,

- eine Schicht (116) auf Grundlage wenigstens eines Dielektrikums, in welcher elektrische Zwischenverbindungs-Schichten (122a, 122b) ausgeführt sind, die elektrisch unter einander und/oder mit den Photodioden (112) und/oder mit den CMOS-Transistoren (114) verbunden sind, wobei die genannte dielektrische Schicht (116) gegen eine erste Oberfläche der Halbleiterschicht (110) angeordnet ist, die einer zweiten Oberfläche der Halbleiterschicht (110) entgegengesetzt gegenüber liegt, durch welche das von dem Bildsensor (100-500) empfangene Licht bestimmungsgemäß eintritt,

- in der dielektrischen Schicht (116) in Ausrichtung mit den Photodioden angeordnete lichtreflektierende Mittel (122b, 130, 132, 136), die wenigstens einen Teil des von dem Bildsensor (100-500) empfangenen Lichts in Richtung zu den Photodioden (112) zu reflektieren vermögen und wenigstens eine Schicht (132) auf Basis eines Materials, das eine Lichtreflexion bewirken kann, umfasst, deren Hauptoberflächen parallel zur ersten Oberfläche der Halbleiterschicht sind, **dadurch gekennzeichnet, dass** die wenigstens eine Schicht (132) auf Grundlage wenigstens eines Materials, das eine Lichtreflexion zu bewirken vermag, zwischen den Zwischenverbindungsschichten (122a, 122b) und der Halbleiterschicht (110) angeordnet und von den elektrischen Kontakten (124) durchsetzt wird, welche die elektrischen Zwischenverbindungsschichten (122a, 122b) mit den Photodioden (112) und/oder mit den CMOS-Transistoren (114) verbinden, und weiter **dadurch gekennzeichnet, dass** die Entfernung zwischen der Schicht (132) aus zur Bewirkung einer Lichtreflexion geeignetem Material und der ersten Oberfläche der Halbleiterschicht (110) einen Betrag im Bereich zwischen 70 nm und 120 nm aufweist.

2. Bildsensor (100-500) nach Anspruch 1, bei welchem die Oberfläche der Photodioden (112), die sich in Ausrichtung mit den Lichtreflexionsmitteln (122b, 130, 132, 136) in einer durch die erste Oberfläche der Halbleiterschicht (110) gehenden Ebene befindet, gleich oder größer als 70 % der Gesamtoberfläche der Photodioden (112) in der genannten durch die erste Oberfläche der Halbleiterschicht (110) gehenden Ebene ist.

3. Bildsensor (100) nach einem der vorhergehenden Ansprüche, bei welchem die Lichtreflexionsmittel wenigstens eine der elektrischen Zwischenverbindungs-Schichten (122 b) umfassen, welche eine Reflexionsoberfläche im Bereich zwischen 50 % und 90 % der Oberfläche der ersten Oberfläche der Halbleiterschicht (110 ) oder der mit der Halbleiterschicht (110) ausgerichteten Oberfläche einer anderen (122 a) der elektrischen Zwischenverbindungsschichten bildet.

4. Bildsensor (100) nach Anspruch 3, bei welchem die Entfernung zwischen der genannten reflektierenden elektrischen Zwischenverbindungsschicht und der ersten Oberfläche der Halbleiterschicht größer oder gleich 200 nm ist.

5. Bildsensor (200) nach einem der Ansprüche 1 oder 2, bei welchem die Lichtreflexionsmittel wenigstens eine Metallschicht (130) umfassen, deren Hauptflächen parallel zur ersten Oberfläche der Halbleiterschicht (110) sind, und dass die elektrischen Zwischenverbindungsschichten (122a, 122b) zwischen der genannten Metallschicht (130) und der Halbleiterschicht (110) angeordnet sind.

6. Bildsensor (200) nach Anspruch 5, bei welchem die Oberfläche einer der Hauptflächen der Metallschicht (130) gleich der ersten Oberfläche der Halbfeüerschicht (110) ist.

7. Bildsensor (200) nach einem der Ansprüche 5 oder 6, bei welchem die Dicke der Metallschicht (130) einen Wert zwischen 10 nm und 100 nm besitzt.

8. Bildsensor (300, 400, 500) nach einem der vorhergehenden Ansprüche, bei welchem die Schicht (132) aus einem zur Bewirkung einer Lichtreflexion geeigneten Material auf Grundlage von Aluminium und/oder von Kupfer und/oder von Chrom und/oder von amorphem Silizium und/oder von polykristallinem Silizium ausgebildet ist und/oder eine Dicke im Bereich zwischen 10 nm und 100 nm besitzt.

9. Bildsensor (400) nach einem der vorhergehenden Ansprüche, bei welchem die Lichtreflexions-Mittel des weiteren eine zweite Schicht (136) auf Grundlage wenigstens eines dielektrischen Materials oder einen leeren Raum umfasst, in Anordnung zwischen der Schicht (132) aus dem zur Bewirkung einer Lichtreflexion geeignetem Material und der ersten Oberfläche der Halbleiterschicht (110).

10. Bildsensor (400) nach Anspruch 9, bei welchem ein Bereich der dielektrischen Schicht (116) zwischen der zweiten dielektrischen Schicht (136) oder dem Leerraum und der ersten Oberfläche der Halbleiterschicht (110) angeordnet ist und eine Dicke im Bereich zwischen 1 nm und 10 nm besitzt.

11. Bildsensor (300, 400, 500) nach einem der vorhergehenden Ansprüche, bei welchem die Dicke der Schicht (132) aus zur Bewirkung einer Lichtreflexion geeignetem Material und/oder die Dicke der dielektrischen Schicht oder Schlichten (136, 116) und/oder die Dicke des Leerraums sich zwischen der ersten Seite der Halbleiterschicht (110) und der Schicht (132) aus dem zur Bewirkung einer Lichtreflexion geeigneten Material gleich der Beziehung

$$\frac{\lambda c \times n}{4}$$

mit

- $\lambda c$ als der zentralen Wellenlänge des Betriebs-Wellenlängenbeichs des Bildsensor (300, 400, 500), welche die Halbleiterschicht (110) durchsetzt,
- und mit n als dem Realteil des optischen Brechungsindex des Materials der genannten Schicht.

12. Bildsensor (500) nach einem der vorhergehenden Ansprüche, bei welchem die Schicht (132) aus dem zur Bewirkung einer Lichtreflexion geeigneten Material elektrisch mit in der Halbleiterschicht (110) gebildeten Dotierungszonen verbunden ist.

13. Verfahren zur Herstellung eines Bildsensor (100-500), das Verfahren umfassend wenigstens die Verfahrensstufen bzw. -schritte:

- Ausbilden dotierter Zonen von Photodioden (112) und von CMOS-Transistoren (114) in einer Schicht (110) auf Grundlage wenigstens eines Halbleiters und mit einer Dicke im Bereich zwischen 1 $\mu$m und 1,5 $\mu$m,
- Ausbilden elektrischer Zwischenverbindungs-schichten (122a, 122b), die elektrisch untereinander und/oder mit den Photodioden (112) und/oder mit den CMOS-Transistoren (114) verbunden sind, in einer Schicht (116) auf Grundlage wenigstens eines Dielektrikums, die gegen eine erste Oberfläche der Schicht (110) auf Halbleiter-Grundlage angeordnet ist, die einer zweiten Oberfläche der Schicht (110) auf Halbleitergrundlage entgegengesetzt gegenüberliegt, durch welche das von dem Bildsensor (100-500) von Außen her empfangene Licht bestimmungsgemäß eintritt,

das Verfahren umfassend des weiteren die Ausbildung von Lichtreffexionsmitteln (122b, 130, 132, 136), die in der dielektrischen Schicht (116) in Ausrichtung mit den Photodioden (112) angeordnet sind und wenigstens einen Teil des von dem Bildsensor (100 - 500) aufgenommenen Lichts in Richtung zu den Photodioden (112) zu reflektieren vermögen, wobei die Lichtsreflexionsmittel wenigstens eine Schicht (132) auf Grundlage wenigstens eines Materials umfasst, das zur Bewirkung einer Lichtreflexion geeignet ist und wobei die Hauptflächen dieser Schicht parallel zu der ersten Oberfläche der Halb-leiterschicht sind, dadurch gekennzeichnet, dass die wenigstens eine Schicht (132) auf Grundlage wenigstens eines zum Bewirken einer Lichtreflexion ge-eigneten Materials zwischen den Zwischenverbin-dungsschichten (122a, 122b) und der Halbleiterschicht (110) angeordnet ist und von elektrischen Kontakten (124) durchsetzt wird, welche die elektrischen Zwischenverbindungsschichten (122a, 122b) mit den Photodioden (112) und/oder den CMOS-Transistoren (114) verbinden,
und weiter **dadurch gekennzeichnet, dass** die Entfernung zwischen der Schicht (132) aus dem zum Bewirken einer Lichtreflexion geeigneten Material und der ersten Oberfläche der Halbleiterschicht (110) einen Wert im Bereich zwischen 70 nm und 120 nm besitzt.

Fig.1

Fig.2

Fig.3

longueur d'onde en nm

FIG.4

400

102

104
106
108
110
114    136    112
132
118
116    120    124    124
122a
122b
126

128

# Fig.5

500

102

104
106
108
110
114    112
132
118
116    120    124    124
122a
122b
126

128

# Fig.6

longueur d'onde en nm

# FIG.7

**EP 2 161 751 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2007052050 A1